# EUROPEAN PATENT APPLICATION

(11) **EP 3 839 700 A1**
(43) Date of publication of application: **23.06.2021**
(21) Application number: 19219138.5
(22) Date of filing: 20.12.2019
(51) Int. Cl.: G06F 3/01

(54) **GESTURE RECOGNITION SYSTEM FOR KITCHEN MACHINES**

(30) Priority: 18.12.2019 PT 2019115991
(71) Applicant: Modelo Continente Hipermercados, S.A., 4464-503 Senhora da Hora (PT)
(72) Inventor: FARIA ROCHA, DUARTE NUNO, 3800-423 AVEIRO (PT)
(74) Representative: do Nascimento Gomes, Rui

(57) **Abstract**

The present application describes a gesture recognition system for kitchen machines. The core of such system is a gesture recognition module, to be coupled to the kitchen machine's body, and preferentially directed towards a user operating said kitchen machine. Said module comprises a sensing unit, operated by a control unit which is connected to a communication interface unit. The module is designed to generate a constant electrical field, propagating three-dimensionally around its surface, forming an actuation zone, and to detect distortions in the electric field caused by a user's hand or finger motion within said actuation zone. Said distortions are then interpreted and assignable to a specific kitchen machine's operative instruction.

## Description

### TECHNICAL FIELD

The present application is enclosed in the area of kitchen machines, in particular kitchen machines which are electrically ran/operated, typically comprising a mixing cup in which automatic mixing actions are performed, and relates to a system for controlling the operation of a kitchen machine. Particularly, the present application discloses a gesture recognition system to control the operation of the kitchen machine based on the gestures performed by a user.

### BACKGROUND ART

Current state of the art solutions prove that it is possible to control the operation of a generic system dispensing a direct contact of an user with such system, either by means of a physical interface - e.g physical keyboard or software keyboard provided in an LCD display- installed in the front- end of system being controlled or through the use of remote interface platform accessible by means of a mobile device application. However, depending on the specificities of each system to be controlled, a certain set of alternatives are more viable from the user's point of view than others.

Particularly, in the field of kitchen machines, the user control operations are typically provided by means of a physical interface with controller buttons being arranged in the front panel of the machines. Alternatively, machine's control can be remotely programmed by users with a mobile device application, through the access to an interface platform hosted in a web-server connected to kitchen machine.

Gesture recognition technologies are known from the art, for controlling the operation of a kitchen machines, and are based in image processing. As an example, document EP2925199 B1 describes a gesture recognition module, that is based on a built-in kitchen machine camera, mounted potentially directed towards the user of the machine, that continuously take pictures for detecting and recognizing the body of the user. For the initialization of the recognition software implemented, the pictures taken by the camera are pre-processed to first detect a user's stable position which is the starting point to perform the movement detecting, recognition and respective conversion into a kitchen machine operative instruction.

The viability of image-based solutions implies meeting demanding operating requirements related to camera characteristics and lighting conditions which, depending on the position of the pair user-machine, in relation to a light source, may not be suitable for executing a recognition software properly, leading to possible gesture detection errors.

### PROBLEM TO BE SOLVED

In order to provide a kitchen machine interaction control mechanism based on gesture recognition technology that overcomes the limitations of the state of the art, the present application describes a gesture recognition system that utilizes an electric field for advance proximity sensing. This approach allows the realization of a user interface by detecting, tracking and classifying the user's hand or finger motion in free space, regardless of the user interaction's lighting conditions.

### SUMMARY

It is an object of the present application a gesture recognition system for kitchen machines. The core of such system is a gesture recognition module, to be coupled to the kitchen machine's body, and preferentially directed towards a user operating said kitchen machine. Said module comprises a sensing unit, operated by a control unit which is connected to a communication interface unit. The module is designed to generate a constant electrical field, propagating three-dimensionally around its surface, forming an actuation zone, and to detect distortions in the electric field caused by a user's hand or finger motion within said actuation zone.

The connection between the gesture recognition module and the kitchen machine is provided by the communication interface unit which is operatively connected to the processing unit of the kitchen machine. It is by means of this connection, that the control unit of the gesture recognition module is able to operate the kitchen machine hardware elements, according to a classified operative movement based on the user's hand or finger motion.

In a particular embodiment, the sensing unit is comprised by one electrode, with a defined geometry, one antenna transmitter and at least one receiver antenna.

In another object of the present application, the system further comprises a validation unit, operatively coupled to the gesture recognition module, and configured to assign a classified operative movement to an operative interaction event for the purpose of relating a user's hand or finger motion detection to a particular kitchen machine operative instruction.

### DESCRIPTION OF FIGURES

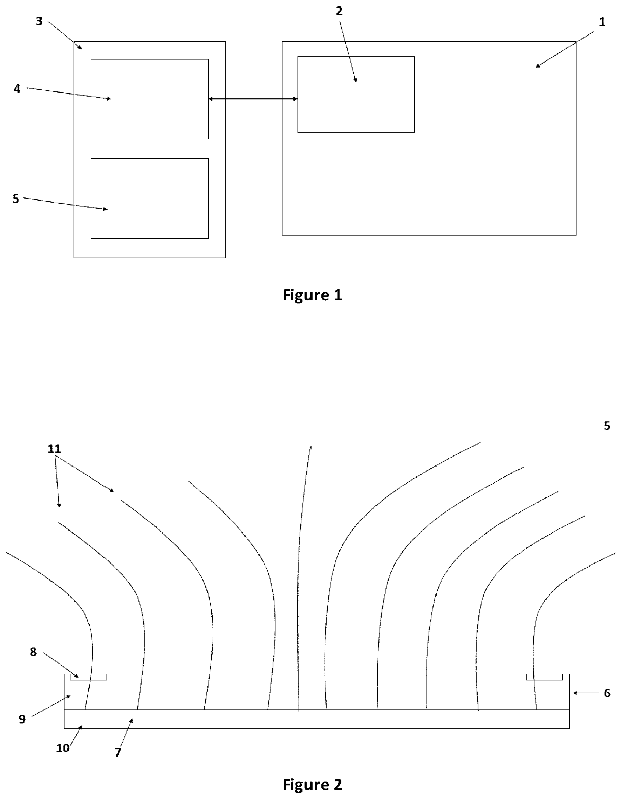

Figure 1 illustrates a diagram block of one embodiment of the system developed. The reference signs represent:
   1 - kitchen machine;
   2 - processing unit;
   3 - gesture recognition module;
   4 - control unit;
   5 - sensing unit.
Figure 2 shows one embodiment of the sensing module, the reference signs represent:
   5 - sensing module;
   6 - electrode;
   7 - transmitter antenna;
   8 - receiver antenna;
   9 - isolating layer;
   10 - ground;
   11- electric field.

### DETAILED DESCRIPTION

The more general and advantageous configurations of the present application are described in the Summary. Such configurations are detailed below in accordance with other advantageous and/or preferred embodiments of implementation of the technology developed.

The present application intends to describe a gesture recognition system for kitchen machines. In the context of the present application, a kitchen machine is a device electrically ran, comprising i) a mixing cup, ii) mixing means provided in the mixing cup, iii) a base station suitable for coupling of the mixing cup and which thereby is able to provide motion to the mixing means, iv) means for automatically measuring weight or volume of food products placed into the mixing cup, v) a processing unit comprising processing means programmed to operate the kitchen machine hardware elements i) to iv).

In an inventive aspect of the present application, the gesture recognition system now developed is comprised by at least one kitchen machine and by a gesture recognition module which is coupled to the kitchen machine's body, preferably, directed towards a user operating said kitchen machine. In one embodiment, the gesture recognition module is built-in the kitchen machine's body, preferentially mounted in the front panel of said kitchen machine, facing the user. Alternatively, the gesture recognition module can be an external peripheral device, to be installed in the kitchen machine through a generic input/output connection port, extending horizontally form the base of the kitchen machine. In both embodiments, the gesture recognition module is able to create an actuation zone ahead of the kitchen machine's body, within which movements/gestures of the user's hand or finger are converted into kitchen machine's operative instructions.

In another inventive aspect of the present application, the gesture recognition module comprises a sensing unit, operated by a control unit which is connected to a communication interface unit. The module is designed to generate a constant electrical field, propagating three-dimensionally around its surface, forming the actuation zone, and to detect distortions in the electric field caused by a user's hand or finger motion within said actuation zone. The connection between the gesture recognition module and the kitchen machine is provided by the communication interface unit which is operatively connected to the processing unit of the kitchen machine. It is by means of this connection, that the control unit of the gesture recognition module is able to operate the kitchen machine hardware elements i) to iv), according to a classified operative movement based on the user's hand or finger motion.

The principle underlying the operation of the gesture recognition module is based on the utilization of an electric field for advanced proximity sensing, allowing the realization of a user interface application by detection, tracking and classification of user's hand or finger motion in free space. Particularly, electric fields are generated by electrical charges by applying direct voltages (DC) to an electrode, resulting in the generation of a constant electric field which propagates three-dimensionally around the surface of said electrode, carrying the electrical charge. By applying alternating voltages (AC), the electrical charges vary over time and, thus, the electric field. When the charge varies sinusoidal with the frequency *f*, the resulting electromagnetic wave is characterized by wavelength *λ*=*c*/*f*, where *c* is the wave propagation velocity - in vacuum, the speed of light. In cases where the wavelength is much larger than the electrode geometry, the magnetic component is practically zero and no wave propagation takes place. The result is quasi-static electrical near-field that can be used for sensing conductive objects such as the human body.

In an alternative embodiment, the sensing unit of the gesture recognition module is comprised by one electrode with a defined geometry, one antenna transmitter and at least one receiver antenna. Alternatively, it is further comprised by an isolating layer between the transmitter antenna and the at least one receiver antenna. The electrode is connected to a direct voltage source power, resulting in the generation of a constant electricfield. Said direct source power can be provided directed by the kitchen machine or through a battery contained in the module. The transmitter antenna is designed to apply alternating voltages to the electrode which varies sinusoidally with a frequency *f*, within a range of operating frequencies of the transmitter. The electrode's geometry may vary, being designed to generate a quasi-static electric field. For that purpose, the electro's geometry must be defined in function of the operating frequency range of the transmitter. The receivers are installed in the electrode's surface and are configured to detect electric field distortions from the varying signals received. At leastone receiver is used for that purpose, but preferentially a plurality of receivers can be installed in different positions along the electrode's surface allowing to increase the detection's accuracy of the user's hand or finger motion. In a particular embodiment the transmitter operates in a range of 100 kHz, which reflects a wavelength of about 3 km. With electrode geometries of 14x14 cm, this wavelength is much larger in comparison. In case a person's hand or finger intrudes the electrical field, the field becomes distorted. The field lines are drawn to the hand due to the conductivity of the human body itself and shunted to ground. Since the three-dimensional electric field decreases locally, four receivers can be used to detect the electric fieldvariations at different positions to measure the origin of the distortion form the varying signals received. This information is then used to calculate the position, track movements and to classify operative movements.

In one embodiment of the system, the control unit of the gesture recognition module is operable to program the operating frequency of the transmitter and to process the data collected by the at least one receiver, in order to measure the origin of the electric field distortion from the varying signals received.

In an alternative embodiment, the gesture recognition module further comprises an external noise sensing unit, operatively connected to the control unit of said gesture recognition module. Said external noise unit can be any processing unit already known from the art, being able to perform noise power measurements. The control unit is configured to automatically reprogram the carrier frequency of the transmitter within its operating frequency range, according to the external noise level sensed by the external noise sensing unit.

In an inventive aspect of the present application, the control unit of the gesture recognition module comprises memory means for storing a local database structure, preferably a relational database. Said database structure is comprised by a plurality of records, each one associating a kitchen machine operative instruction with a classified operative movement derivable from the user's hand or finger motion. In connection to this, the control unit also comprises processing means that are adapted to manipulate data related to detected distortions in the electric field, generated by the user's hand or finger motion within the actuation zone, in order to create an operative interaction event assignable to said classified operative movement. Particularly, the processing means of the gesture recognition module's control unit are arranged to create said operative interaction event based on:
calculating an initial position data of the user's hand or finger based on the detected distortions in the electric field at a position within the actuation zone;
tracking movements data of the user's hand or finger motion based on the detected distortions in the electric field at different positions within the actuation zone.

In another innovative aspect of the present application, the system developed is further comprised by a validation unit. Said unit is operatively connected to the control unit of the gesture recognition module and configured to assign a classified operative movement to an operative interaction event. For that purpose, the validation unit comprises memory means for storing target data, relating a classified operative movement with a respective operative interaction event. It also comprises processing means configured to create a training model adapted to identify patterns in a training data, related to operative interaction events created by the processing unit of the gesture recognition module, that map the classified operative movement's target data. By means of executing a machine learning methodology for classifying a user's gesture as an operative movement, the system becomes operable to coupe with slight changes in the user's hand or finger motion. This is done by collecting a set of records from past used interactions - target data - associated to a respective kitchen machine's operative instruction, and comparing them with actual operative interaction events - training data. In one embodiment, the validation unit is directly mounted in the gesture recognition module. Alternatively, the validation unit is hosted in an external data processing server, that is operatively coupled to the communication interface of the gesture recognition module by means of a bidirectional wireless data communication link.

As will be clear to one skilled in the art, the present invention should not be limited to the embodiments described herein, and a number of changes are possible which remain within the scope of the present invention.

Of course, the preferred embodiments shown above are combinable, in the different possible forms, being herein avoided the repetition all such combinations.

## Claims

1. Gesture recognition system for kitchen machines, such kitchen machine being electrically ran and comprising i) a mixing cup, ii) mixing means provided in the mixing cup, iii) a base station suitable for coupling of the mixi ng cup and which thereby is able to provide motion to the mixing means, iv) means for automatically measuring weight or volume of food products placed into the mixing cup, v) a processing unit comprising processing means programmed to operate the kitchen machine hardware elements i) to iv);
the gesture recognition system being **characterized by** comprising at least one kitchen machine and a gesture recognition module coupled to the kitchen machine's body, directed towards a user operating said kitchen machine;
the gesture recognition module comprising a sensing unit, operated by a control unit which is connected to a communication interface unit; the module being designed a) to generate a constant electrical field, propagating three-dimensionally around its surface, forming an actuation zone, and b) to detect distortions in the electric field caused by a user's hand or finger motion within said actuation zone;
wherein,
the communication interface unit is operatively connected to the processing unit of the kitchen machine; and
the control unit of the gesture recognition module is configured to operate the kitchen machine hardware elements i) to iv), through the communication interface unit, according to a classified operative movement based on the user's hand or finger motion.

2. System according to claim 1, wherein the sensing unit is comprised by one electrode with a defined geometry, one antenna transmitter and at least one receiver antenna.

3. System according to claim 2, wherein the electrode is connected to a direct voltage source power, resulting in the generation of a constant electric field.

4. System according to any of the previous claims 2 or 3, wherein the transmitter antenna is designed to apply alternating voltages to the electrode, said alternating voltages varying sinusoidally with a frequency f, within a range of operating frequencies of the transmitter.

5. System according to claim 4, wherein the geometry of the electrode is designed to generate a quasi-static electric field being defined in function of the operating frequency range of the transmitter.

6. System according to any of the previous claims 2 to 5, wherein the at least one receiver is installed in the electrode's surface and is configured to detect electric field distortions from the varying signals received.

7. System according to any of the previous claims 2 to 6, wherein the control unit of the gesture recognition module is operable to:
program the operating frequency of the transmitter;
process the data collected by the at least one receiver to measure the origin of the electric field distortion from the varying signals received.

8. System according to previous claim 7, wherein the gesture recognition module further comprises an external noise sensing unit, operatively connected to the control unit of saidgesture recognition module; said control unit being configured to program the frequency of operation of the transmitter according to the external noise level sensed by the external noise sensing unit.

9. System according to any of the previous claims 2 to 8, wherein the sensing unit comprises an isolating layer between the transmitter antenna and the at least one receiver antenna.

10. System according to any of the previous claims wherein the control unit of the gesture recognition module comprises:
memory means for storing a local database structure, preferably a relational database; saiddatabase structure comprising a plurality of records, eachone associating a kitchen machine operative instruction with a classified operative movement;
processing means adapted to manipulate data related to detected distortions in the electric field in order to create an operative interaction event assignable to a classified operative movement.

11. System according to claim 10, wherein the processing means of the gesture recognition module's control unit are arranged to create an operative interaction event based on:
calculating an initial position data of the user's hand or finger based on the detected distortions in the electric field at a position within the actuation zone;
tracking movements data of the user's hand or finger motion based on the detected distortions in the electric field at different positions within the actuation zone.

12. System according to claim 10 or 11, further comprising a validation unit operatively connected to the control unit of the gesture recognition module and configured to assign a classified operative movement to an operative interaction event; said validation unit comprising:
memory means for storing target data, relating a classified operative movement with a respective operative interaction event;
processing means configured to create a training model adapted to identify patterns in a training data, related to operative interaction events created by the control unit of the gesture recognition module, that map the classified operative movement's target data.

13. System according to claim 12, wherein the validation unit is directly mounted in the gesture recognition module; or the validation unit is hosted in an external data processing server, operatively coupled to the communication interface of the gesture recognition module by means of a bidirectional wireless data communication link.

14. System according to any of the previous claims wherein the gesture recognition module is mounted in a front panel of the kitchen machine.

15. System according to any of the previous claims 1 to 13 wherein the gesture recognition module extends horizontally form the base of the kitchen machine.
